## Europäisches Patentamt

## European Patent Office

## Office européen des brevets

(11) Veröffentlichungsnummer: **0 163 871 B1**

(12) # EUROPÄISCHE PATENTSCHRIFT

(45) Veröffentlichungstag der Patentschrift:
**30.03.88**

(51) Int. Cl.⁴: **H 01 L 29/62**, H 01 L 21/28

(21) Anmeldenummer: **85104547.6**

(22) Anmeldetag: **15.04.85**

(54) **Verfahren zum Herstellen von aus Doppelschichten aus hochschmelzenden Metallsiliziden und dotiertem polykristallinem Silizium bestehenden Gate-Elektroden.**

(30) Priorität: **22.05.84 DE 3419034**

(43) Veröffentlichungstag der Anmeldung:
**11.12.85 Patentblatt 85/50**

(45) Bekanntmachung des Hinweises auf die Patenterteilung:
**30.03.88 Patentblatt 88/13**

(84) Benannte Vertragsstaaten:
**AT CH DE FR GB IT LI NL SE**

(56) Entgegenhaltungen:
**EP - A - 0 002 165**
**EP - A - 0 071 029**
**US - A - 4 329 706**
**US - A - 4 362 597**

**IEEE TRANSACTIONS ON ELECTRON DEVICES, Band ED-27, Nr. 8, August 1980, Seiten 1425-1430, IEEE, New York, US; A.K. SINHA et al.: "MOS compatibility of high-conductivity TaSi2/n+ poly-Si gates"**
**IEEE JOURNAL OF SOLID-STATE CIRCUITS, Band SC-15, Nr. 4, August 1980, Seiten 474-482, IEEE, New York, US; S.P. MURARKA et al.: "Refractory silicides of Titanium and Tantalum for low-resistivity gates interconnects"**

(73) Patentinhaber: **Siemens Aktiengesellschaft Berlin und München, Wittelsbacherplatz 2, D-8000 München 2 (DE)**

(72) Erfinder: **Neppl, Franz, Dr., St. Quirin-Platz 6, D-8000 München 90 (DE)**
Erfinder: **Schwabe, Ulrich, Dr., Plievierpark 14, D-8000 München 83 (DE)**
Erfinder: **Hieber, Konrad, Dr., Laubensteinstrasse 7, D-8214 Bernau (DE)**

**Beschreibung**

Die Erfindung betrifft ein Verfahren zum Herstellen von aus Doppelschichten aus hochschmelzenden Metallsiliziden und dotiertem polykristallinem Silizium (Polyzidschicht) bestehenden Gate-Elektroden, von Feldeffekttransistoren, insbesondere für integrierte komplementäre MOS-Feldeffekttransistorschaltungen (CMOS), bei dem die Herstellung der Source/Drain-Bereiche durch Ionenimplantation nach dem Erzeugen der Gate-Elektrode unter Verwendung der Gate-Elektrode als Implantationsmaske vorgenommen werden.

Zur Erhöhung von Schalt- und Zugriffszeiten in integrierten MOS-Schaltungen wird in modernen Prozessen $n^+$-Polysilizium durch eine Doppelschicht aus durch Belegung von stark phosphordotiertem polykristallinem Silizium mit einem hochschmelzenden Metallsilizid, zum Beispiel Tantaldisilizid, Wolframdisilizid oder Molybdänsilizid, ersetzt. Solche Doppelschichten werden als Polyzide bezeichnet. Ihre Eigenschaften sind aus einem Aufsatz von S.P. Murarka aus J. Vac. Sci. Technol., 17 (4) Juli/August 1980 auf den Seiten 775 bis 792 zu entnehmen.

Die hohe Phosphor-Konzentration in Polysilizium hat ein relativ dickes natürliches Oxid auf dem Polysilizium zur Folge, was zu unreproduzierbaren Polysilizium/Silizid-Grenzflächen führen kann. Dies behindert die unter Umständen zur Einstellung der genauen Stöchiometrie der Metalldisilizide erforderliche Interface-Reaktion, beeinflusst das Ätzverhalten und die Oxidation des Polyzids sowie den Verlust von Phosphor während nachfolgender Temperaturbehandlungen. Schwankender oder gar lokal unterschiedlicher Phosphorgehalt in der Polyzidschicht bedingt unreproduzierbare Ätzung und kann vor allem bei thermischer Reoxidation zur Polyzidschädigung führen. Ausserdem wird eine relativ dicke Polysiliziumschicht gefordert, die unnötig hohe Stufen in der Polysilizium-Ebene verursacht. Wie aus einem Aufsatz von C. Koburger et al. aus dem J. Electrochem. Soc., Vol. 129, No. 6 (1982), auf den Seiten 1307 bis 1312 zu entnehmen ist, treten bei dünneren Schichten verstärkt Oxiddurchbrüche auf. Ausserdem sind ohne erheblichen Mehraufwand zwei Leitfähigkeitstypen in der Polysiliziumebene nicht zu erzeugen, was bei CMOS-Schaltungen zu relativ schlechten p-Kanal-Eigenschaften führt (ungünstige Austrittsarbeit). Die Verwendung von $n^+$- und $p^+$-Polysilizium ohne Metallsilizid auf einem Chip stellt für n- und p-Kanal-MOS-Feldeffekttransistoren zwar Gates mit günstiger Austrittsarbeit zur Verfügung, erfordert aber Metallbrücken zwischen $n^+$- und $p^+$-Polysilizium sowie zusätzliche Maskierungsschritte.

Die Mindestanforderungen an die Polysiliziumdicke konnte bei der Herstellung von Polyziden bei Verwendung von Molybdänsilizid ($MoSi_2$) dadurch entschärft werden, dass zunächst undotiertes polykristallines Silizium verwendet wird, das erst nach der Molybdändisilizid-Abscheidung durch Ionenimplantation von Phosphor dotiert wird. Dadurch wird die Dicke des durch thermische Oxidation entstandenen Oxids (Lageroxid) zwischen Polysilizium und Silizid verringert. Schädliche lokale Interface-Reaktionen werden durch homogene Reaktionen ersetzt, und es treten keine Gateoxidschädigungen mehr auf. Nähere Einzelheiten sind aus einem Bericht von M. Fukumoto et. al. aus dem Paper 7–7 im Digest of techn. papers of the 1983 Symposion on VLSItechnology, Hawai, auf den Seiten 98/99 zu entnehmen.

Ein Verfahren der eingangs genannten Art ist beispielsweise aus EP-A-0 071 029 im Hinblick auf integrierte MOSFET-Strukturen bekannt.

Die Aufgabe, die der Erfindung zugrundeliegt, besteht nun darin, ein Verfahren anzugeben, mit dem ohne grossen technologischen Mehraufwand auf einem Chip gleichzeitig Polyzid-Gates mit $n^+$-Polysilizium (n-Kanal) und $p^+$-Polysilizium (p-Kanal) erzeugt werden können, ohne dass unreproduzierbare Polysilizium/Silizid-Grenzflächen entstehen. Ausserdem soll die Abscheidung dikker Schichten vermieden werden, die der Planarisierung der Bauelementstrukturen entgegenwirkt.

Die erfindungsgemässe Aufgabe wird durch ein Verfahren der eingangs genannten Art dadurch gelöst, dass

a) zunächst eine aus undotiertem polykristallinem Silizium bestehende Schicht auf der mit der Gateoxidschicht versehenen Substratoberfläche abgeschieden wird,

b) darauf die Metallsilizidschicht aufgebracht wird,

c) die Polyzidschicht strukturiert wird, um die Gate-Elektroden zu erzeugen,

d) nacheinander nach jeweiliger Maskierung der anderen Kanaltypen die Source/Drain-Bereiche implantiert werden, wobei auch die Metallsilizidschichten den Gate-Elektroden entsprechend dotiert werden, und

e) nach Abscheidung des Zwischenoxids durch eine Temperaturbehandlung die durch die Ionenimplantation eingebrachten Dotierstoffe aus dem Metallsilizid in das darunter liegende polykristalline Silizium eindiffundiert werden.

Durch das Verfahren nach der Lehre der Erfindung wird der CMOS-Prozess mit Polyzidgate mit $n^+$- und $p^+$-Polysilizium dadurch wesentlich vereinfacht, dass die entsprechenden Dotierstoffe, wie Arsen, Phosphor bzw. Bor, die bei den zwei Source/Drain-Implantationen sowieso in das Silizid der n-Kanal bzw. p-Kanal Transistor-Gates implantiert werden, durch die nachfolgende Temperaturbehandlung (Drive-in) ins unter dem Metallsilizid liegende Polysilizium eingetrieben werden. Die $n^+$- und $p^+$-Anteile des Polysilizium sind durch das Metallsilizid von vornherein kurzgeschlossen. Bei Verwendung von Tantaldisilizid ist die Ausdiffusion der genannten Dotierstoffe aus dem Silizid in das Silizium durch Sekundär-Ionen-Massenspektrometrie und elektrische Messungen nachgewiesen worden. Bei Verwendung von Phosphor ist zur Verhinderung von Dotierstoffverlust durch die Silizidoberfläche beim Drive-in eine Oxidabdeckung des Silizids vor dem Drive-in nötig; bei Verwendung von Bor muss das durch thermische Oxidation entstandene Oxid (Lageroxid) völlig entfernt werden, was zum Beispiel durch Überätzen in der Silizidabscheideanlage geschehen kann (zum Beispiel Sputterätzen bei Sputterprozessen).

Das Verfahren der Polysilizium-Dotierung nach der Metallsilizidabscheidung ermöglicht es, polykristallines Silizium und Metallsilizid hintereinander ohne Belüftung in einer Anlage abzuscheiden. Dies kann erfolgen durch zum Beispiel Siliziumaufdampfen und Tantal/SiliziumCo-Dampfen oder durch Silizium-Sputtern und Tantaldisilizid-Sputtern oder durch chemische Abscheidung von Silizium aus der Gasphase (CVD) und CVD-Tantaldisilizid. Dadurch kann eine reproduzierbar saubere (nahezu) oxidfreie Grenzschicht erreicht werden. Das zuletzt erwähnte kombinierte CVD-Verfahren bietet die höchste Siliziumreinheit, die sauberste Grenzfläche zum Silizid und eine bestmögliche Kantenbedeckung.

Die Vorteile des erfindungsgemässen CMOS-Polyzid-Prozesses lassen sich wie folgt zusammenfassen:

1. Beibehaltung der Polysilizium/SiO$_2$-Grenzfläche,

2. Möglichkeit der kombinierten Polysilizium/Silizid-Abscheidung,

3. Minimales oder kein Lageroxid zwischen Polysilizium und Silizid,

4. leichtere Planarisierung durch dünnes Polysilizium (geringere Stufenhöhe),

5. Möglichkeit der Herstellung von «buried contacts» zu n$^+$- und p$^+$-Diffusionsgebieten,

6. Erleichterung der Polyzidstrukturierung und Reoxidation infolge fehlender schwankender Dotierstoffkonzentrationen und unterschiedlicher Qualität der Silizid/Polysilizium-Grenzfläche,

7. Einfache Realisierung von p$^+$- und n$^+$-Polyzid auf einem Chip (Austrittsarbeit des Gatematerials dem Transistortyp angepasst), und

8. Optimale p-Kanal-Eigenschaften (CMOS) durch günstige Austrittsarbeit des Gatematerials aus p$^+$-Polysilizium.

Bis auf die unter Punkt 7 und 8 genannten Möglichkeiten kommen diese Vorteile auch bei NMOS-Prozessen zum Tragen.

Weitere Ausgestaltungen der Erfindung, insbesondere ein Vorschlag für eine mögliche Prozessführung zur Herstellung einer CMOS-Anordnung, sind aus den Unteransprüchen zu entnehmen.

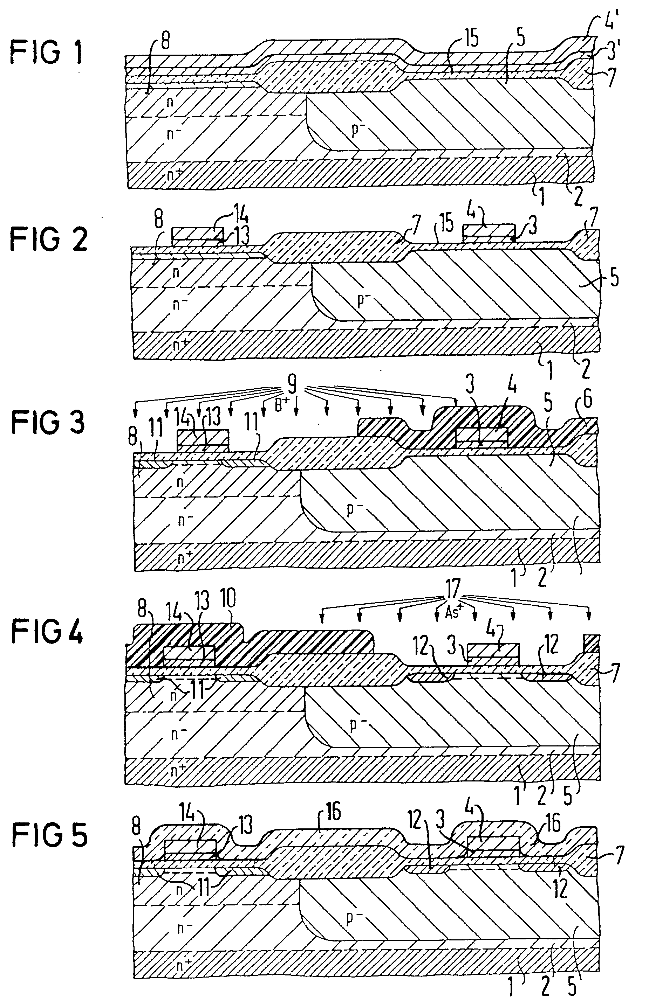

Nachfolgend wird anhand der Fig. 1 bis 5, welche die erfindungswesentlichen Verfahrensschritte im Schnittbild darstellen, eine CMOS-Prozessführung beschrieben. Für gleiche Teile gelten in allen Figuren gleiche Bezugszeichen.

Fig. 1: Auf der Anordnung, bestehend aus dem n$^+$-dotierten Siliziumkristall 1, der n$^-$-dotierten epitaktischen Schicht 2, der im Substrat 1, 2 erzeugten p$^-$-Wanne 5 und der n-Wanne 8 sowie der auf dem Substrat erzeugten Feldoxidbereiche 7, wird durch thermische Oxidation der gesamten Oberfläche die Dicke der Gateoxidschicht 15 mit 30 nm eingestellt. Dann erfolgt der erste erfindungswesentliche Schritt der Abscheidung der undotierten polykristallinen Siliziumschicht 3' in einer Schichtdicke von zum Beispiel 50 nm durch eine chemische Gasabscheidung (CVD). Darauf wird in einer Schichtdicke von ca. 200 nm eine aus Tantaldisilizid bestehende Schicht 4', ebenfalls durch einen CVD-Prozess, aufgebracht. Da das Polysilizium erfindungsgemäss noch undotiert bleiben kann, ist es möglich, die beiden Schichten 3', 4' hintereinander ohne Belüftung in einer Anlage abzuscheiden. Dadurch kann eine reproduzierbar saubere (nahezu) oxidfreie Grenzschicht erreicht werden.

Fig. 2: Die Strukturierung der aus dem undotierten polykristallinen Silizium (3') und dem Tantaldisilizid (4') bestehenden Polyzidschicht 3', 4' erfolgt durch reaktives Ionenätzen, zum Beispiel in einem Chlor-Bortrichlorid-Ätzgemisch unter Verwendung einer Fotolackmaske. Zur Kristallisation der Tantaldisilizidschichten 4, 14 wird eine Temperung bei 900 °C (20 min) durchgeführt. Es entsteht die in Fig. 2 gezeigte Anordnung.

Fig. 3: Im Anschluss an die Strukturierung der Gates (3, 4; 13, 14) wird eine Fotolackstruktur 6, welche die Bereiche der n-Kanaltransistoren in der p-Wanne 5 bedeckt, aufgebracht und eine Bor-Ionenimplantation 9 zur Erzeugung der Source/Drain-Bereiche 11 der p-Kanaltransistoren in der n-Wanne 8 mit einer Dosis und Energie von $5 \times 10^{15}$ cm$^{-2}$ und 25 keV durchgeführt. Dabei wird gleichzeitig Bor in das Tantalsilizid 14 der p-Kanaltransistoren implantiert.

Fig. 4: Nach Ablösen der Fotolackstruktur 6 wird eine weitere Fotolackstruktur 10, welche die Bereiche der p-Kanaltransistoren in der n-Wanne 8 bedeckt, aufgebracht und eine Arsen-Ionen-Implantation 17 mit einer Dosis und Energie von $5 \times 10^{15}$ cm$^{-2}$ und 80 keV zur Erzeugung der Source/Drain-Bereiche 12 für den n-Kanaltransistor durchgeführt. Dabei wird gleichzeitig das Tantalsilizid 4 dotiert.

Fig. 5: Nach dem Entfernen der Fotolackstruktur 10 und nach dem Aufbringen der SiO$_2$ bestehenden 700 nm dicken Zwischenoxidschicht 16 wird eine Temperaturbehandlung in Stickstoff/Wasserstoffatmosphäre zum Eintreiben der implantierten Bor- und Arsenionen (9; 17) bei 900 °C (60 min) durchgeführt. Es entstehen die Source/Drain-Bereiche 11 der p-Kanaltransistoren und die Source/Drain-Bereiche 12 der n-Kanaltransistoren. Gleichzeitig erfolgt eine Eindiffusion der Dotierstoffe aus der Tantalsilizidschicht 4, 14, in das polykristalline Silizium 3, 13.

Die Fertigstellung der Anordnung, wie Öffnen der Kontaktlochbereiche und Herstellen der Metall-Leiterbahnebene, erfolgt nach bekannten Verfahrensschritten der CMOS-Technologie.

**Patentansprüche**

1. Verfahren zum Herstellen von aus Doppelschichten aus hochschmelzenden Metallsiliziden und dotiertem polykristallinen Silizium (Polyzidschicht) bestehenden Gate-Elektroden (3, 4; 13, 14) von Feldeffekttransistoren, insbesondere für integrierte komplementäre MOS-Feldeffekttransistorschaltungen (CMOS), bei dem die Herstellung der Source/Drain-Bereiche (11; 12) durch Ionen-Implantation nach dem Erzeugen der Gate-Elektroden (3, 4; 13, 14) unter Verwendung der Gate-Elektrode als Implantationsmaske vorgenommen wird, dadurch gekennzeichnet, dass

a) zunächst eine aus undotiertem polykristallinem Silizium bestehende Schicht (3') auf der mit der Gateoxidschicht (15) versehenen Substratoberfläche abgeschieden wird,

b) darauf die Metallsilizidschicht (4') aufgebracht wird,

c) die Polyzidschicht (3', 4') strukturiert wird, um die Gate-Elektroden (3, 4; 13, 14) zu erzeugen,

d) nacheinander nach jeweiliger Maskierung (6; 10) der anderen Kanaltypen die Source/Drain-Bereiche (11; 12) implantiert werden, wobei auch die Metallsilizidschichten (4; 14) der Gate-Elektroden entsprechend dotiert werden, und

e) nach Abscheidung des Zwischenoxids (16) durch eine Temperaturbehandlung die durch die Ionenimplantation (9; 17) eingebrachten Dottierstoffe aus dem Metallsilizid (4; 14) in das darunter liegende polykristalline Silizium (3; 13) eindiffundiert werden.

2. Verfahren nach Anspruch 1, dadurch gekennzeichnet, dass die Polyzidschicht (3', 4') durch Aufdampfen, Aufstäuben (Sputtern) oder durch chemische Dampf-Abscheidung (CVD) hergestellt wird.

3. Verfahren nach Anspruch 1 oder 2, dadurch gekennzeichnet, dass die Schichtdicke der undotierten, polykristallinen Siliziumschicht (3') auf kleiner als 300 nm eingestellt wird.

4. Verfahren nach einem der Ansprüche 1 bis 3, dadurch gekennzeichnet, dass die Schichtdicke der zuerst aufgebrachten polykristallinen Siliziumschicht (3') auf einen Bereich zwischen 20 bis 300 nm und die Schichtdicke der Metallsilizidschicht (4') auf einen Bereich von 100 bis 400 nm eingestellt wird.

5. Verfahren nach einem der Ansprüche 1 bis 4, dadurch gekennzeichnet, dass als Metallsilizide (4; 14) die Disilizide der Metalle von Tantal, Molybdän, Wolfram, Titan verwendet werden.

6. Verfahren nach einem der Ansprüche 1 bis 5, dadurch gekennzeichnet, dass für die Ionen-Implantation (9; 17) die Dotierstoffe Arsen, Phosphor und Bor verwendet werden.

7. Verfahren zum Herstellen einer sowohl n- als auch p-Kanal-Transistoren enthaltenden integrierten Schaltung (CMOS) nach einem der Ansprüche 1 bis 6, bei dem die Verfahrensschritte bis einschliesslich der Erzeugung des Gateoxids (15) und die Herstellung des Isolationsoxids (16) und der Leiterbahnebene nach bekannten Verfahrensschritten der CMOS-Technologie durchgeführt werden, gekennzeichnet durch den Ablauf der folgenden Verfahrensschritte:

a) Abscheidung einer undotierten, polykristallinen, ca. 50 nm dicken Siliziumschicht (3') auf das mit der Gateoxidschicht (15) versehene, die n- bzw. p-Wannenbereiche (5; 8) und die Feldoxidbereiche (7) enthaltende Substrat (1, 2),

b) Abscheidung einer aus Tantaldisilizid bestehenden Schicht (4') in einer Schichtdicke im Bereich von 200 nm,

c) Strukturierung der aus Silizium und Tantaldisilizid bestehenden Doppelschicht (3', 4') mittels Fotolithographie, um die Gate-Elektroden (3, 4; 13, 14) zu erzeugen,

d) Durchführung einer Temperung im Bereich von 900 °C zur Kristallisation von Tantaldisilizid (4; 14),

e) Durchführung einer ersten Fotolacktechnik (6) zur Abdeckung der n-Kanal-Bereiche,

f) Implantation von Bor-Ionen (9) mit einer Dosis und Energie von $5 \times 10^{15}$ cm$^{-2}$ und 25 keV zur Erzeugung der Source/Drain-Bereiche (11) für den p-Kanal-Transistor und Bordotierung des Tantalsilizids (14),

g) Durchführung einer zweiten Fotolacktechnik (10) nach Ablösung der ersten Fotolackmaske (6) zur Abdeckung der p-Kanal-Bereiche,

h) Implantation von Arsen- und/oder Phosphor-Ionen (17) mit einer Dosis und Energie von $5 \times 10^{15}$ cm$^{-2}$ und 80 keV zur Erzeugung der Source/Drain-Bereiche (12) für den n-Kanal-Transistor und n$^+$-Dotierung des Tantalsilizids (4),

i) Aufbringen der Zwischenoxidschicht (16) in einer Schichtdicke im Bereich von 700 nm und

j) Temperaturbehandlung im Bereich von 900 °C zur Eindiffusion der durch die Verfahrensschritte f) und h) implantierten Ionen, insbesondere der aus dem Tantalsilizid (4; 14) in die darunter liegende polykristalline Siliziumschicht (3; 13).

8. Verfahren nach Anspruch 7, dadurch gekennzeichnet, dass die Doppelschicht (3', 4') aus polykristallinem Silizium und Tantaldisilizid durch chemische Gasabscheidung (CVD) hergestellt wird.

9. Verfahren nach Anspruch 7 oder 8, dadurch gekennzeichnet, dass die Temperaturbehandlung nach Verfahrensschritt j) in Stickstoff/Wasserstoff Atmosphäre mindestens 60 min lang durchgeführt wird.

**Claims**

1. A process for the production of gate electrodes (3, 4; 13, 14), consisting of double layers of high-melting point metal silicides and of doped polycrystalline silicon (polycide layer), of field effect transistors, in particular for integrated, complementary MOS field effect transistor circuits (CMOS), where the source/drain zones (11; 12) are formed by ion implantation following the production of the gate electrode (3, 4; 13, 14), using the gate electrode is implantation mask, characterised in that

a) a layer (3'), made of undoped, polycrystalline silicon, is first deposited onto the substrate surface which is provided with the gate oxide layer (15),

b) to this is applied the metal silicide layer (4'),

c) the polycide layer (3', 4') is structured in order to form the gate electrodes (3, 4; 13, 14),

d) after in each case masking (6; 10) of the other channel types, the source/drain zones (11; 12) are successively implanted, at which time the metal silicide layers (4; 14) of the gate electrodes are also correspondingly doped and

e) following the disposition of the intermediate oxide layer (16), by means of a heat treatment the dopants, which have been introduced by the ion implantation (9; 17), are caused to diffuse out of the metal silicide (4; 14) into the underlying, polycrystalline silicon (3; 13).

2. A process as claimed in claim 1, characterised in that the polycide layer (3', 4') is produced by vapour deposition, sputtering or chemical vapour deposition (CVD).

3. A process as claimed in claim 1 or 2, characterised in that the layer thickness of the undoped, polycrystalline silicon layer (3') is set at less than 300 nm.

4. A process as claimed in one of the claims 1 to 3, characterised in that the layer thickness of the initially applied, polycrystalline silicon layer (3') is set within a range of 20 to 300 nm, and the layer thickness of the metal silicide layer (4') is set within a range of 100 to 400 nm.

5. A process as claimed in one of the claims 1 to 4, characterised in that the disilicides of the metals tantalum, molybdenum, tungsten and titanium are used as metal silicides (4; 14).

6. A process as claimed in one of the claims 1 to 5, characterized in that the dopants arsenic, phosphorus and boron are used for the ion implantation (9; 17).

7. A process for the production of an integrated circuit (CMOS), containing both n- and p-channel transistors, as claimed in one of the claims 1 to 6, where the process steps, up to an including the formation of the gate oxide layer (15) and the formation of the insulating oxide layer (16) and of the conductor path level, are carried out in accordance with known process steps of CMOS-technology, characterised by the sequence of the following process steps:

a) deposition of an undoped, polycrystalline, approx. 50 nm thick silicon layer (3') on the substrate (1, 2) which is provided with the gate oxide layer (15) and which contains the n- and p-trough zones (5; 8) and the field oxide zones (7),

b) deposition of a layer (4'), consisting of tantalum disilicide, in a layer thickness in the region of 200 nm,

c) structuring of the double layer (3', 4'), consisting of silicon and tantalum disilicide, by means of photolithography in order to produce the gate electrodes (3, 4; 13, 14),

d) annealing in the region of 900 °C in order to crystallise the tantalum disilicide (4; 14),

e) a first photo-resist step (6) to cover the n-channel zones,

f) implantation of boron-ions (9) in a dose and energy of $5\times10^{15}$ cm$^{-2}$ and 25 keV respectively in order to form the source/drain zones (11) for the p-channel transistor, and boron doping of the tantalum silicide (14),

g) a second photo-resist step (10) following the removal of the first photo-resist mask (6) in order to cover the p-channel zones,

h) implantation of arsenic and/or phosphorus ions (17) in a dose and energy of $5\times10^{15}$ cm$^{-2}$ and 80 keV respectively in order to form the source/drain zones (12) for the n-channel transistor, and n$^+$ doping of the tantalum silicide (4),

i) application of the intermediate oxide layer (16) in a layer thickness in the region of 700 nm and

j) heat treatment in the region of 900 °C in order to diffuse the ions implanted by process steps f) and h), in particular from the tantalum silicide (4; 14), into the underlying, polycrystalline silicon layer (3; 13).

8. A process as claimed in claim 7, characterised in that the double layer (3', 4') of polycrystalline silicon and tantalum disilicide is produced by chemical gas deposition (CVD).

9. A process as claimed in claim 7 or 8, characterised in that the heat treatment in accordance with process step j) is carried out for at least 60 min in a nitrogen/hydrogen atmosphere.

**Revendications**

1. Procédé de fabrication d'électrodes de grille (3, 4; 13, 14), constituées de couches doubles en silicium métallique à point de fusion élevée et en silicium polycristallin dopé (couches de polysiure) de transistors à effet de champ, notamment de circuits intégrés à transistors à effet de champ MOS complémentaires (CMOS), dans lequel la fabrication des zones de source/drain (11, 12) est effectuée par implantation d'ions après la production de l'électrode de grille (3, 4; 13, 14) en utilisant l'électrode de grille comme masque d'implantation, caractérisé en ce qu'il consiste:

a) à déposer d'abord une couche (3') en silicium polycristallin non dopé sur la surface de substrat munie de la couche d'oxyde de grille (15);

b) à déposer ensuite la couche de siliciure métallique (4');

c) à structurer la couche de polysiure (3', 4') pour produire les électrodes de grille (3, 4; 13, 14);

d) à implanter les zones de source/drain (11; 12) l'une après l'autre après masquage (6; 10) de l'autre type de canal, les couches de siliciure métallique (4; 14) des électrodes de grille étant également dopées d'une manière correspondante; et

e) après dépôt de l'oxyde intermédiaire (16), à faire diffuser par un traitement thermique la substance de dopage introduite par implantation d'ions (9, 17) du siliciure métallique (4, 14) dans le silicium polycristallin (3, 13) sous-jacent.

2. Procédé suivant la revendication 1, caractérisé en ce qu'il consiste à préparer la couche de polysiure (3', 4') par dépôt en phase vapeur, par pulvérisation cathodique (sputter) ou par dépôt chimique en phase vapeur (CVD).

3. Procédé suivant la revendication 1 ou 2, caractérisé en ce qu'il consiste à régler l'épaisseur de la couche de silicium polycristallin (3') non dopé à une valeur inférieure à 300 nm.

4. Procédé suivant l'une des revendications 1 à 3, caractérisé en ce qu'il consiste à régler l'épaisseur de la couche de silicium (3') polycristallin déposé en premier dans une plage comprise entre 20 et 300 nm et l'épaisseur de la couche de siliciure métallique (4') dans une plage comprise entre 100 et 400 nm.

5. Procédé suivant l'une des revendications 1 à 4, caractérisé en ce qu'il consiste à utiliser comme

silicium métallique (4, 14) les disciliciures des métaux que sont le tantale, le molybdène, le tungstène, le titane.

6. Procédé suivant l'une des revendications 1 à 5, caractérisé en ce qu'il consiste à utiliser pour l'implantation d'ions (9, 17) les substances de dopage que sont l'arsenic, le phosphore et le bore.

7. Procédé de fabrication d'un circuit intégré (CMOS) comportant à la fois de transistors à canel n et à canel p suivant l'une des revendications 1 à 6, dans lequel on effectue les stades du procédé jusqu'à et y compris la production de l'oxyde de grille (15) et la fabrication de l'oxyde d'isolation (16) et du plan des pistes conductrices par les stades de procédé connus de la technologie CMOS, caractérisé en ce qu'il consiste à effectuer les stades de procédé suivants:

a) dépôt d'une couche de silicium (3') non dopée, polycristallin, de 50 nm d'épaisseur environ sur le substrat (1, 2) muni de la couche d'oxyde de grille (15) et contenant les zones de cuvette de type n et p (5, 8) et les zones d'oxyde de champ (7);

b) dépôt d'une couche (4') en disciliciure de tantale, en une épaisseur de l'ordre de 200 nm;

c) structuration de la couche double (3', 4') constituée de silicium et de disiliciure de tantale par photolithographie pour produire les électrodes de grille (3, 4; 13, 14);

d) exécution d'un recuit à environ 900 °C pour cristalliser le disciliciure de tantale (4, 14);

e) mise en œuvre d'une première technique par vernis photosensible (6) pour recouvrir les zones de canal de type n;

f) implantation d'ions de bore (9) avec une dose et avec une énergie de $5 \times 10^{15}$ cm$^{-2}$ et de 25 keV, pour produire des zones de source/drain (11) pour le transistor à canel de type p et pour doper par du bore le siliciure de tantale (14);

g) mise en œuvre d'une deuxième technique par vernis photosensible (10) après dissolution du premier masque de vernis photosensible (6) pour recouvrir les zones de canal de type p;

h) implantation d'ions arsenic et/ou phosphore (17) avec une dose et avec une énergie de $5 \times 10^{15}$ cm$^{-2}$ et de 80 keV pour produire les zones de source/drain (12) pour le transistor à canal de type n et pour le dopage n$^+$ du siliciure de tantale (4);

i) dépôt de la couche d'oxyde intermédiaire (16) en une épaisseur de l'ordre de 700 nm; et

j) traitement thermique à une température d'environ 900 °C pour faire diffuser les ions implantées par les stades du procédé f) et h), notamment ceux du siliciure de tantale (4, 14), dans la couche de silicium (3, 13) polycristallin sous-jacente.

8. Procédé suivant la revendication 7, caractérisé en ce qu'il consiste à fabriquer la couche double (3', 4') en silicium polycristallin et en disiliciure de tantale par dépôt chimique en phase gazeuse (CVD).

9. Procédé suivant la revendication 7 ou 8, caractérisé en ce qu'il consiste à effectuer le traitement thermique après la stade de procédé j) dans une atmosphère d'azote/hydrogène pendant au moins 60 minutes.

0163871

FIG 1

FIG 2

FIG 3

FIG 4

FIG 5

7